# EUROPEAN PATENT SPECIFICATION

(11) **EP 2 007 843 B1**
(45) Date of publication and mention of the grant of the patent: **02.12.2009**
(21) Application number: 07735146.8
(22) Date of filing: 16.03.2007
(51) Int. Cl.: C09K 11/06, H01L 51/52, H05B 33/26, H01L 51/00

(54) **ORGANIC ELECTROLUMINESCENT DEVICE**
ORGANISCHE ELEKTROLUMINESZENZVORRICHTUNG
DISPOSITIF ELECTROLUMINESCENT ORGANIQUE

(30) Priority: 03.04.2006 EP 06112167
(43) Date of publication of application: 31.12.2008
(73) Proprietor: Philips Intellectual Property & Standards GmbH, 20099 Hamburg (DE); Koninklijke Philips Electronics N.V., 5621 BA Eindhoven (NL)
(72) Inventor: BÖRNER, Herbert Friedrich, NL-5656 AA Eindhoven (NL); LÖBL, Hans-Peter, NL-5656 AA Eindhoven (NL); RAASCH, Detlef, NL-5656 AA Eindhoven (NL)
(74) Representative: Bekkers, Joost J.J
(86) International application number: PCT/IB2007/050916
(87) International publication number: WO 2007/113707

(56) References cited:
- WO-A-2005/081750
- GB-A- 2 368 455
- US-A- 5 885 498
- US-A1- 2005 263 779

## Description

The invention relates to an organic electroluminescent device having a transparent electrode having good conductive properties and a method to produce the organic electroluminescent device.

Organic electroluminescent devices (OLEDs) comprise a layered structure (the EL structure) that is applied to a substrate, the layered structure usually comprising a luminescent organic layer (the light-emitting layer), a hole-conducting layer, an anode and a cathode. The typical thicknesses of the individual layers are of the order of 100 nm. The typical voltages applied to the EL structure are between 2 V and 10 V. In so-called bottom emitters, the organic electroluminescent device emits light through a transparent substrate, typically of glass. This being the case, the electrode that is arranged between the substrate and the light-emitting layer, typically the anode is likewise transparent. A standard transparent and electrically conductive material for the anode is indium tin oxide (ITO), which can be deposited satisfactorily on the substrate as a thin layer. In large-area OLEDs having a light-emitting area of some hundreds of square centimeters, high currents (operating current) have to be distributed over the area of the anode, at an operating voltage as above, almost without losses, to enable the OLED to emit light of a brightness that is uniform over the area. Lossless transport of the electrical current is only possible if the resistance of the electrodes is sufficiently low. In the case of bottom emitters, this requirement is met, for the second electrode on the side remote from the substrate, by means of a reflective metal, such as aluminum, which is normally used. A transparent ITO electrode on the other hand has, for a transmission of 90%, a resistance per unit of area of at least 10Ω/area. This resistance per unit of area that ITO has is too high to ensure that there is uniform brightness from large-area OLEDs.

Document US 5 885 498 discloses an organic electroluminescent device having a patterned transparent electrode, wherein on a substrate a current distributing layer is formed as a patterned first layer which has slits made therein at intervals to separate the current distributing layer into a number of segments. A hole injecting electrode layer (a second layer) covers the current distributing layer deposited on the substrate, filling the slits between the segments, while the electrode layer separates the first layer from a hole transporting layer.

Document US 5,399,936 discloses transparent ITO anodes having locally inset metal strips to reduce the electrical resistance along the ITO anode. The metal strips constitute a conductor of low resistance parallel to the ITO anode. For large-area OLEDs, the current would have to be distributed over the ITO anode by means of a metal grid. A metal grid of this kind would have to be produced by expensive lithographic processes. In addition, a grid of this kind constitutes a non-planar surface for the application of the rest of the stack of layers making up the OLED, which has an adverse effect on the way on which the layers that are to be applied grow and may result in local increases in the electrical field at the edges of the metal strips.

It is therefore an object of the present invention to provide a reliable and inexpensive large-area organic electroluminescent device that emits light of a uniform brightness over the emitting area.

This object is achieved by an organic electroluminescent device for emitting light, comprising a substrate, a first electrode and a second electrode and having at least one light-emitting layer arranged between the electrodes, wherein the first electrode, which is intended to transmit the light generated in the organic light-emitting layer, comprises a planar current distributing layer to stimulate uniform light emission with connected areas of titanium nitride intended to conduct an operating current arranged between areas of titanium oxide intended to transmit the light generated. The terms titanium nitride and titanium oxide mean in this case materials having the compositions TiNₓ, where 0.5 ≤ x ≤1.5, and TiO_{y}, where 1.0 ≤ y ≤ 2.5, respectively. Titanium nitride is a material having good electrical conductive properties, which properties, over the range 0.5 ≤ x ≤ 1.5 are better by factor of 4 or more than those of the usual transparent electrode material ITO. However, titanium nitride is not transparent. At nitrogen contents x of approximately 1, TiNₓ is of a golden color. Titanium oxide on the other hand is, it is true, a high-resistance material at oxygen contents of 1.0 ≤ y ≤2.5 but, unlike titanium nitride, is transparent. This being the case, it is possible, in a single layer, both for the current required for the generation of light to be distributed over a large area of electrode by the structure of titanium nitride conductor tracks with far lower current losses than would be the case with an ITO electrode, and for the light generated in the light-emitting layer to be emitted through the transparent regions of titanium oxide.

The advantage of the titanium nitride/titanium oxide system lies in the ease with which it can be produced in contrast to known conductor track systems, such for example as a network of thin aluminum strips, where expensive lithographic and etching processes are required. The titanium nitride/titanium oxide system is applied to the substrate as a compact planar layer of titanium nitride and, by a thermal process, is converted locally into titanium oxide without this changing the planar nature of the layer. This thermal conversion process does not require any expensive lithographic or etching processes and can be performed easily, accurately and quickly with, for example, a laser. In this way, a structure of conductor tracks corresponding to the structure of aluminum conductor tracks and having intervening transparent regions is produced without the need to accept the disadvantages of a non-planar base for the application of further layers. At the same time, the current-distributing layer constitutes a layer for chemically protecting the further layers that are to be applied from the substrate. To produce uniform light emission, even distribution of the current by means of the structure of conductor tracks can be achieved by having a small spacing between the individual titanium nitride conductor tracks. The transmitting ability of the first electrode on the other hand, and hence the brightness of the electroluminescent device, is determined by the ratio between the regions of titanium nitride and titanium oxide in the current-distributing layer.

Another advantage is the high refractive index of titanium oxide which, for a wavelength of 550 nm, may for example vary, depending on the oxygen content, from 2.3 (Ti₂O₃) through 2.4 (TiO) to a maximum of 2.71 (TiO₂). The organic light-emitting layer typically has a refractive index of 1.8 to 2.0, which means that when light enters the current-distributing layer there is an optical transition from an optically thinner medium into an optically denser medium at which no total reflection occurs. This being the case, all the light that strikes the regions of titanium oxide is coupled into the current-distributing layer. This shortens the average distance traveled by the light until it emerges into the current-distributing layer and thus reduces the risk of re-absorption in the light-emitting layer, which improves the light yield of the organic electroluminescent device.

In another embodiment, the first electrode also comprises a conductive layer on the side adjacent the light-emitting layer. This conductive layer may comprise, in one embodiment, an organic polymer. By this conductive layer, the current distributed by the structure of conductor tracks is distributed even more widely around the conductor tracks, which means that, when there is a larger spacing between the individual conductor tracks, the current nevertheless enters the light-emitting layer with a uniform distribution and the same uniform light emission can thus be achieved. The larger spacing that is possible between the individual conductor tracks makes it possible for the transparent regions to represent a higher proportion of the total area of the current-distributing layer.

In a further embodiment, the first electrode is of a thickness of between 50 nm and 1000 nm, depending on whether or not an additional conductive layer is applied to the current-distributing layer. For it to have the requisite conductive properties, the minimum thickness for a first electrode comprising merely the current-distributing layer is 50 nm. A first electrode that comprises the conductive layer and is more than 1000 nm thick is no longer fit for purpose for an effective production process.

In a further embodiment, a transmitting layer of a transparent material having a high refractive index is arranged on the side of the first electrode remote from the organic light-emitting layer. What is termed a high refractive index is any refractive index that is higher than the refractive index of the light-emitting layer or, where a further conductive layer is present between the current-distributing layer and the light-emitting layer, that is higher than the refractive index of the further conductive layer. For the total avoidance of total reflection when the light enters the regions of titanium oxide in the current-distributing layer, the thickness of the optically denser material should be greater than the wavelength of the light emitted by the light-emitting layer. With thin current-distributing layers of the order of, for example, 100 nm, the transmitting layer having a high refractive index would have to be of a thickness of at least 600 nm if the total thickness of the layer of high refractive index (thickness of the current-distributing layer plus thickness of the transmitting layer) were to be greater than all the wavelengths in the visible spectrum. With thicker current-distributing layers, the transmitting layer could be thinner by the appropriate amount.

The invention also relates to a method of producing an organic electroluminescent device for emitting light as claimed in claim 1, which method comprises the following steps:
- application of a planar current-distributing layer of titanium nitride to a substrate,
- production of connected areas to conduct an operating current, and of areas arranged between the connected areas, for transmitting light in the current-distributing layer, by the local conversion of the titanium nitride into titanium oxide by means of a suitable local treatment at temperature in an oxygen-containing atmosphere,
- application of further layers comprising at least one organic light-emitting layer for emitting light.

The current-distributing layer (subsequently to be of titanium nitride/titanium oxide) is first applied to the substrate as a layer of titanium nitride. The step of converting the titanium nitride locally into titanium oxide does not change the planar nature of the layer when it occurs. This thermal conversion process does not require any expensive lithographic or etching processes and, in a further embodiment, is to be performed easily, accurately and quickly with a laser. At the same time, the current-distributing layer constitutes a layer for chemically protecting the further layers that are to be applied from the substrate without it being necessary for additional layers to be applied to perform this function. By this method, there can be made available, reliably and inexpensively, an organic electroluminescent device in which the current for operating the organic electroluminescent device can be distributed even over large areas of electrode in such a way that the organic electroluminescent device is able to emit light of a uniform brightness over its entire area. What is meant by the term "treatment at temperature" is the targeted and locally confined heating of a material. What is suitable as an oxygen-containing atmosphere is for example air.

In another embodiment of the method of producing an organic electroluminescent device, the application of further layers comprises a conductive layer that is applied to the current-distributing layer. By this conductive layer, the current that is distributed by the structure of conductor tracks is somewhat more widely distributed in the region around the conductor tracks, which means that, when the spacing between the individual conductor tracks is larger, the same uniform emission of light can nevertheless be achieved. The larger spacing that is possible between the individual conductor tracks makes it possible for the transparent regions to represent a higher proportion of the total area of the current-distributing layer. The process of applying this conductive layer is facilitated by the fact that the said layer can be applied to a planar current-distributing layer.

In one embodiment of the method of producing an organic electroluminescent device, the side of the substrate that is intended for the application of the current-distributing layer is coated with a transmitting layer of a transparent material having a high refractive index before the current-distributing layer is applied. What is referred to as a high refractive index is any refractive index that is higher than the refractive index of the substrate.

In a further embodiment of the method of producing an organic electroluminescent device, the transmitting layer comprises titanium dioxide because, depending on the phase, titanium dioxide has a refractive index of between 2.52 and 2.71.

These and other aspects of the invention are apparent from and will be elucidated with reference to the embodiments described hereinafter.

In the drawings:
Fig. 1 is a view from the side, in section, of an embodiment of an organic electroluminescent device according to the invention on the section line A-B shown in Fig. 2.
Fig. 2 is a plan view of the light-emitting side of the organic electroluminescent device according to the invention shown in Fig. 1, with section line A-B indicated, and
Fig. 3 is a side view, in section, showing a further embodiment of the organic electroluminescent device according to the invention.

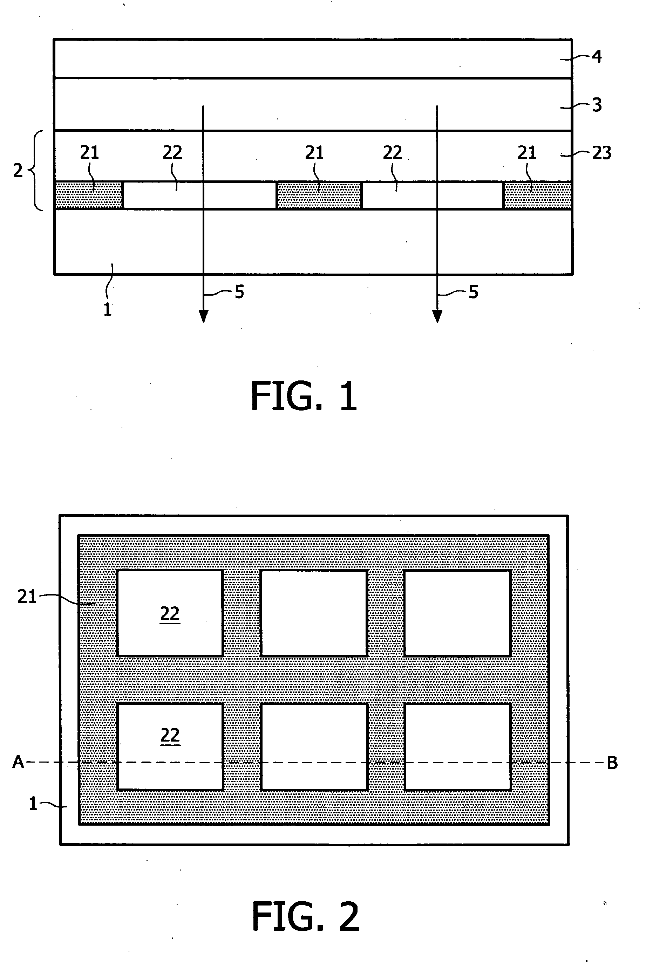

Fig. 1 shows an embodiment of an organic electroluminescent device according to the invention comprising a substrate 1, a first electrode 2 comprising a current-distributing layer 21, 22 and a conductive layer 23, an organic light-emitting layer 3 and a second electrode 4, the said device forming what is called a bottom emitter (light emission through a transparent substrate). In bottom emitters the second electrode 4, forming the cathode, is typically produced to be reflective, from for example a metal such as aluminum, while the transparent first electrode 2 acts as an anode. The refractive index of the transparent substrate 1 may vary in this case between 1.4 and 2.0, which is accomplished by the use of, for example, boron silicate glass having a refractive index n = 1.45, PMMA having an n = 1.49, PET having an n = 1.65 or Schott highly refractive glasses such as SF57 having an n=1.85.

The current-distributing layer 21, 22 comprises regions of titanium nitride 21 to distribute the current and transparent regions of titanium oxide 22. On many substrates, including glass for example, thin layers of titanium nitride (TiNₓ) are notable for having good electrical conductivities, with a resistance of approximately 25 * 10⁻⁶ Ωcm for TiNₓ where x is approximately equal to 1, which is many times lower than that of a corresponding layer of ITO. Layers of titanium nitride adhere very well to smooth substrate such for example as glass, have a smooth surface free of any roughnesses and are very strong mechanically. Thin layers of titanium nitride can be applied by deposition processes such for example as sputtering. In this process, titanium material is ablated from what is called a target by particle bombardment and is deposited on a substrate situated opposite. If this happens in a nitrogen-containing atmosphere, then what is deposited on the substrate is not titanium but titanium nitride, the nitrogen content being set in the coating process by way of the partial pressure of the nitrogen. The layer of titanium nitride that is deposited is of a golden color. Typical thicknesses of layers of titanium nitride that are intended for local conversion into titanium oxide are of the order of 150 nm, in which case the thickness can be varied to suit the field of application and the treatment at temperature.

The regions of titanium oxide 22 shown in Fig. 1 are produced by heating titanium nitride in an oxygen-containing atmosphere. At temperatures above 600°C, titanium combines with oxygen to form titanium oxide, the nitrogen of the original layer of titanium nitride being released. The oxygen content y of the layer of TiOy depends in this case on the temperature and the oxygen content of the atmosphere during the conversion process. To produce a structure of conductor tracks of titanium nitride, the heating has to be confined locally in order to maintain sufficiently large areas of titanium oxide within the planar layer. This may for example be achieved by irradiating the layer of titanium nitride with a laser. The local temperature profile (the lateral temperature distribution and the temperature distribution in the depthwise direction) can be acted on by way of the pulse length and pulse power with a laser in pulsed operation. Short pulses give heating that decreases with increasing distance from the surface of the laser-treated layer. A high laser power gives a high maximum temperature in the temperature profile. If the laser beam is moved across the layer of titanium nitride at a suitable speed then, at a suitable ratio between pulse height and pulse length, the region in which titanium nitride is converted into titanium oxide in an oxygen-containing atmosphere can be very exactly set laterally (parallel to the surface of the layer of titanium nitride) and vertically (perpendicularly to the surface of the layer of titanium nitride). The setting of the vertical temperature profile is important because, on the one hand, it would be desirable to have only transparent titanium oxide along the path followed by the light 5 (see Fig. 1) from the organic light-emitting layer through the first electrode 2 and, on the other hand, it would be desirable for the risk of the substrate starting to melt, due to too high a temperature in the laser treatment, to be kept as low as possible. For example, a 200 nm thick layer of titanium nitride can be converted into titanium oxide by irradiation with a laser at a wavelength of 647 nm, a pulse length of 80 µs, a pulse power of 30 mW (pulse height), a diameter for the beam of light at the surface of the layer of titanium nitride of 1 µm, and movement of the laser beam across the surface at a speed of 5 m/s.

The purpose of the conductive layer 23 that is applied to the current-distributing layer 21, 22 is to distribute the current more widely laterally than is accomplished by the structure of conductor tracks along. This happens to a greater degree the thicker is the conductive layer 23. If the conductive layer 23 is of a suitable thickness and the regions of titanium nitride and titanium oxide 21 and 22 are suitably arranged, it is possible to obtain a current distribution that is uniform over the entire area. Because the light 5 emitted has to pass through the conductive layer 23, only transparent materials can be used for the said conductive later 23. Conductive materials having beneficial properties for production are conductive polymers such for example as PEDOT (Poly(3,4-ethylenedioxythiophene).

Fig. 2 is a plan view of the light-emitting face, which in this case is the transparent substrate 1, of the organic electroluminescent device according to the invention shown in Fig. 1. Line A-B indicates the plane of section on which the view from the side in Fig. 1 is taken. The way in which the current-distributing layer 21, 22 is divided into regions of titanium nitride 21 and titanium oxide 22 that is shown in Fig. 2 is only one example. The structure of conductor tracks comprising connected regions of titanium nitride 21 may, depending on the embodiment, for example be produced in a different way by a different treatment at temperature by laser. The free way in which the laser beam can be guided makes possible any design patterns composed of regions of titanium nitride and titanium oxide. However, for the purpose of current distribution the regions of titanium nitride 21 should form a connected structure of conductor tracks. The width parallel to the surface (lateral extent) of the regions of titanium nitride 21 between the regions of titanium oxide 22 depends on the desired emitting properties of the organic electroluminescent device. If what is desired is a uniform brightness not only over all the regions of titanium oxide 22 but over the entire area of the substrate 1, then the regions of titanium nitride 21 must be of a small lateral extent so that the light 5 from adjacent transparent regions 22 is able to mix. An additional layer for light diffusion applied to the substrate may further improve the uniformity of brightness over the entire area of the substrate.

An electroluminescent device according to the invention may also be produced with a first electrode 2 not having a conductive layer 23. The even current distribution over the entire area of the first electrode that is required for uniform brightness is given by the structure of titanium nitride conductor tracks in the current-distributing layer. If the structure of conductor tracks is laid out as a network of laterally thin lines of titanium nitride with intervening regions 22 of titanium oxide that are likewise thin in the lateral direction, then the viewer will see a uniform perceived brightness from the organic electroluminescent device because the light emitted through the individual transparent regions 22 of titanium oxide will overlap and will make possible emission of a uniform brightness over the area of the substrate.

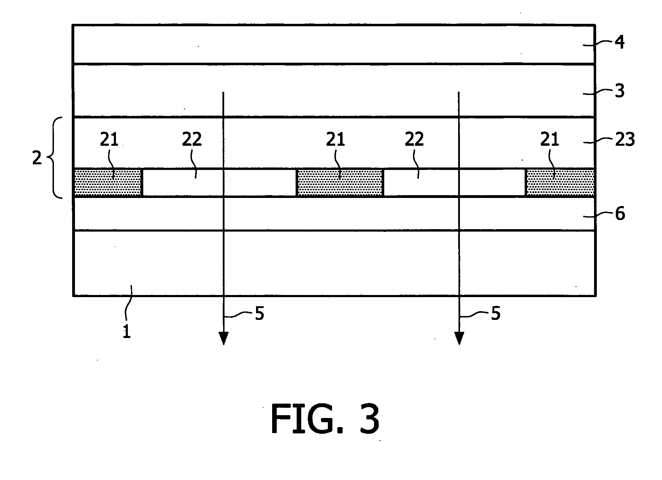

The embodiment of an organic electroluminescent device according to the invention that is shown in Fig. 3 has, between the current-distributing layer 21, 22 and the substrate 1, an additional transmitting layer 6 having a high refractive index to improve the coupling out of the light. What is termed a high refractive index is any refractive index that is higher than the refractive index of the conductive layer 23. In alternative embodiments where there is no conductive layer 23, the term "high refractive index" means a refractive index that is higher than the refractive index of the light-emitting layer 3. For the total avoidance of total reflection when the light 5 enters the transparent regions 22 of titanium oxide in the current-distributing layer 21, 22, the thickness of the optically denser material (the titanium oxide plus the material of the transmitting layer 6 that is situated above it in the direction of propagation of the light) should be greater than the wavelength of the light 5 emitted by the light-emitting layer 3. With thin current-distributing layers 21, 22 of the order of, for example, 100 nm, the transmitting layer 6 having a high refractive index would have to be of a thickness of at least 600 nm if the total thickness of the layer of high refractive index (thickness of the current-distributing layer 21, 22 plus thickness of the transmitting layer 6) in the direction of emission of the light 5 were to be greater than all the wavelengths in the visible spectrum. With thicker current-distributing layers 21, 22, the transmitting layer 6 could be thinner by the appropriate amount. The same is true if the wavelength of the light 5 emitted is confined to shorter wavelengths in the visible spectrum, such as blue light for example. A suitable material for a transmitting layer 6 is for example titanium oxide having a refractive index of between 2:52 and 2.72. The use of titanium oxide as a material for the transmitting layer 6 is advantageous because in this way, for the same oxygen content, there is no optical interface with the transparent regions of titanium oxide 22 in the current-distributing layer 21, 22.

In a further embodiment, the structure of conductor tracks comprising connected regions of titanium nitride 21 is produced in such a way that, as well as performing the current-distributing function, the structure of conductor tracks also forms an optical diffuser grid. This is the case when the structure of conductor tracks is produced as a network of thin strips of titanium nitride 21. The width of the strips of titanium nitride 21 parallel to the interface with the conductive layer 23 or with the light-emitting layer 3 should be of the same order of magnitude in this case as the wavelength of the light 5 emitted. What is advantageous for the light-diffusing effect is a spacing between adjacent strips of titanium nitride 21 that is likewise of the same order of magnitude as the wavelength. Simultaneously with its optical effect, a structure of conductor tracks of this kind also makes it possible for current to be uniformly distributed over the area of the first electrode, which means that a conductive layer 23 would not be required for the uniform transmission of light.

In other embodiments, an organic electroluminescent arrangement according to the invention may have further layers in addition to those shown in Fig. 1. For example, between the cathode, typically the second electrode 4, and the light-emitting layer 3, there may be arranged an electron injection layer of a material having a low work function and between the anode, typically the first electrode 2, and the light-emitting layer 3, there may be arranged, in addition, a hole injection layer.

What are used as an organic material for the light-emitting layer 3 are for example light-emitting polymers (PLEDs) or small light-emitting organic molecules that are embedded in an organic hole-transporting or electron-transporting matrix material. An OLED having small light-emitting molecules in the organic electroluminescent layer is also referred to as a SMOLED (small molecule organic light emitting diode). To improve efficiency, the organic light-emitting layer 3 may, in addition, comprise a hole-transporting layer (HTL) on the anode side and an electron-transporting layer (ETL) on the cathode side. What may be used as materials for the HTL layer are for example 4,4',4"-tris(N-(3-methyl-phenyl)-N-phenylamino)-triphenyl amine (MTDATA), doped with tetrafluorotetracyanoquinodimethane (F4-TCNQ) and a hole-transporting layer of, for example, triaryl amines, diaryl amines, tristilbene amines or a mixture of polyethylene dioxythiophene (PDOT) and poly(styrene sulfonate). What may be used as materials for an ETL layer are for example tris(8-hydroxyquinoline) aluminum (Alq₃), 1,3,5-tris(1-phenyl-1H-benzimidiazol-2-yl) benzene (TPBI) or low-electron heterocycles such as 1,3,4-oxadiazoles or 1,2,4-triazoles. In the embodiment having what is termed a SMOLED layer, the light-emitting layer may for example comprise iridium complexes as light-emitting materials, embedded in a matrix material such for example as 4,4',4"-tris(N-carbazolyl)-triphenylamine (TCTA), 2,9-dimethyl-4,7-diphenyl-1,10-phenanthroline (BCP) or 1,3,5-tris(1-phenyl-1H-benzimidazol-2-yl) benzene (TPBI) or N,N-diphenyl-N,N-di(3-methyl-phenyl)-benzidine (TPD). An organic light-emitting layer 3 is typically of an overall thickness of between 100 nm and 150 nm.

The embodiments that have been elucidated by reference to the drawings and in the description are only examples of an organic electroluminescent device according to the invention and are not to be construed as limiting the claims to these examples. Alternative embodiments are also conceivable by the person skilled in the art, and these too are covered by the scope of the claims. The numbering of the dependent claims is not intended to imply that other combinations of the claims may not also constitute advantageous embodiments of the invention.

## Claims

1. An organic electroluminescent device for emitting light, comprising a substrate (1), a first electrode (2) and a second electrode (4) and having at least one light-emitting layer (3) arranged between the electrodes (2, 4), wherein the first electrode (2), which is intended to transmit the light (5) generated in the organic light-emitting layer (3), comprises a planar current distributing layer (21, 22) to stimulate uniform light emission with connected areas of titanium nitride (21) intended to conduct an operating current arranged between areas of titanium oxide (22) intended to transmit the light (5) generated.

2. An organic electroluminescent device as claimed in claim 1, **characterized in that** the first electrode (2) also comprises a conductive layer (23) on the side adjacent the light-emitting layer (3).

3. An organic electroluminescent device as claimed in claim 2, **characterized in that** the conductive layer (23) comprises an organic polymer.

4. An organic electroluminescent device as claimed in any one of the preceding claims, **characterized in that** the first electrode (2) is of a thickness of between 50 nm and 1000 nm.

5. An organic electroluminescent device as claimed in any one of the preceding claims, **characterized in that** a transmitting layer (6) of a transparent material having a high refractive index is arranged on the side of the first electrode (2) remote from the organic light-emitting layer (3).

6. A method of producing an organic electroluminescent device for emitting light as claimed in claim 1, which method comprises the following steps:
- application of a planar current-distributing layer (21, 22) of titanium nitride to a substrate,
- production of connected areas (21) to conduct an operating current, and of areas (22) arranged between the connected areas (21), for transmitting light in the current-distributing layer (21, 22), by the local conversion of the titanium nitride (21) into titanium oxide (22) by means of a suitable local treatment at temperature in an oxygen-containing atmosphere,
- application of further layers comprising at least one organic light-emitting layer (3) for emitting light (5).

7. A method of production as claimed in claim 6, **characterized in that** the local treatment at temperature is performed by a laser.

8. A method of production as claimed in claim 6 or 7, **characterized in that** the application of further layers comprises a conductive layer (23) that is applied to the current-distributing layer (21, 22).

9. A method of production as claimed in claims 6 to 8, **characterized in that** the side of the substrate (1) that is intended for the application of the current-distributing layer (21, 22) is coated with a transmitting layer (6) of a transparent material having a high refractive index before the current-distributing layer (21, 22) is applied.

10. A method of production as claimed in claim 9, **characterized in that** the transmitting layer (6) comprises titanium dioxide.

## Patentansprüche

1. Organische Elektrolumineszenzeinrichtung zum Emittieren von Licht, mit einem Substrat (1), einer ersten Elektrode (2) und einer zweiten Elektrode (4) und mindestens einer, zwischen den Elektroden (2, 4) angeordneten, Licht emittierenden Schicht (3), wobei die erste Elektrode (2), die das in der organischen, Licht emittierenden Schicht (3) erzeugte Licht (5) übertragen soll, eine planare Stromverteilungsschicht (21, 22), um gleichmäßige Lichtemission anzuregen, mit Anschlussbereichen (21) aus Titannitrid umfasst, die einen Betriebsstrom leiten sollen und zwischen Bereichen (22) aus Titanoxid angeordnet sind, die das erzeugte Licht (5) übertragen sollen.

2. Organische Elektrolumineszenzeinrichtung nach Anspruch 1, **dadurch gekennzeichnet, dass** die erste Elektrode (2) ebenfalls eine leitende Schicht (23) auf der Seite in Angrenzung an die Licht emittierende Schicht (3) umfasst.

3. Organische Elektrolumineszenzeinrichtung nach Anspruch 2, **dadurch gekennzeichnet, dass** die leitende Schicht (23) ein organisches Polymer umfasst.

4. Organische Elektrolumineszenzeinrichtung nach einem der vorangegangenen Ansprüche, **dadurch gekennzeichnet, dass** die erste Elektrode (2) eine Dicke zwischen 50 nm und 1000 nm aufweist.

5. Organische Elektrolumineszenzeinrichtung nach einem der vorangegangenen Ansprüche, **dadurch gekennzeichnet, dass** auf der Seite der ersten Elektrode (2) von der organischen, Licht emittierenden Schicht (3) entfernt eine Übertragungsschicht (6) aus lichtdurchlässigem Material mit einem hohen Brechungsindex angeordnet ist.

6. Verfahren zur Herstellung einer organischen Elektrolumineszenzeinrichtung zum Emittieren von Licht nach Anspruch 1, wobei das Verfahren die folgenden Schritte umfasst:
- Auftragen einer planaren Stromverteilungsschicht (21, 22) aus Titannitrid auf einem Substrat,
- Vorsehen von Anschlussbereichen (21) zum Leiten eines Betriebsstroms sowie von, zwischen den Anschlussbereichen (21) angeordneten Bereichen (22) zum Übertragen von Licht in der Stromverteilungsschicht (21, 22) durch die lokale Umwandlung des Titannitrids (21) in Titanoxid (22) mit Hilfe einer geeigneten, lokalen Behandlung bei Temperatur in einer Sauerstoff enthaltenden Atmosphäre,
- Auftragen von weiteren Schichten mit mindestens einer organischen, Licht emittierenden Schicht (3) zum Emittieren von Licht (5).

7. Verfahren zur Herstellung nach Anspruch 6, **dadurch gekennzeichnet, dass** die lokale Behandlung bei Temperatur durch einen Laser durchgeführt wird.

8. Verfahren zur Herstellung nach Anspruch 6 oder 7, **dadurch gekennzeichnet, dass** das Auftragen weiterer Schichten eine leitende Schicht (23) umfasst, die auf die Stromverteilungsschicht (21, 22) aufgebracht wird.

9. Verfahren zur Herstellung nach einem der Ansprüche 6 bis 8, **dadurch gekennzeichnet, dass** die Seite des Substrats (1), die für das Aufbringen der Stromverteilungsschicht (21, 22) bestimmt ist, vor Auftragen der Stromverteilungsschicht (21, 22) mit einer Übertragungsschicht (6) aus einem lichtdurchlässigen Material mit einem hohen Brechungsindex beschichtet wird.

10. Verfahren zur Herstellung nach Anspruch 9, **dadurch gekennzeichnet, dass** die Übertragungsschicht (6) Titandioxid umfasst.

## Revendications

1. Dispositif électroluminescent organique pour émettre de la lumière, comprenant un substrat (1), une première électrode (2) et une deuxième électrode (4) et ayant au moins une couche émettrice de lumière (3) qui est déposée entre les électrodes (2, 4), dans lequel la première électrode (2) qui est destinée à transmettre la lumière (5) étant générée dans la couche organique émettrice de lumière (3) comprend une couche planaire de distribution de courant (21, 22) pour stimuler l'émission de lumière uniforme avec des zones connectées de nitrure de titane (21) qui sont destinées à conduire un courant de fonctionnement et qui sont disposées entre des zones d'oxyde de titane (22) qui sont destinées à transmettre la lumière (5) étant générée.

2. Dispositif électroluminescent organique selon la revendication 1, **caractérisé en ce que** la première électrode (2) comprend également une couche conductrice (23) du côté qui est adjacent à la couche émettrice de lumière (3).

3. Dispositif électroluminescent organique selon la revendication 2, **caractérisé en ce que** la couche conductrice (23) comprend un polymère organique.

4. Dispositif électroluminescent organique selon l'une quelconque des revendications précédentes 1 à 3, **caractérisé en ce que** la première électrode (2) présente une épaisseur dans la gamme comprise entre 50 nm et 1000 nm.

5. Dispositif électroluminescent organique selon l'une quelconque des revendications précédentes 1 à 4, **caractérisé en ce qu'**une couche de transmission (6) d'un matériau transparent ayant un indice de réfraction élevé est déposée du côté de la première électrode (2) qui se situe dans un sens s'éloignant de la couche émettrice organique (3).

6. Procédé de production d'un dispositif électroluminescent organique pour émettre de la lumière selon la revendication 1, lequel procédé comprend les étapes suivantes consistant à :
- déposer une couche planaire de distribution de courant (21, 22) de nitrure de titane sur un substrat,
- produire des zones connectées (21) pour conduire un courant de fonctionnement et des zones (22) qui sont disposées entre les zones connectées (21) pour transmettre de la lumière dans la couche de distribution de courant (21, 22) par la conversion locale du nitrure de titane (21) en de l'oxyde de titane (22) au moyen d'un traitement local approprié à une température dans une atmosphère contenant de l'oxygène,
- appliquer de nouvelles autres couches comprenant au moins une couche organique émettrice de lumière (3) pour émettre de la lumière (5).

7. Procédé de production selon la revendication 6, **caractérisé en ce que** le traitement local à une température est réalisé par un laser.

8. Procédé de production selon la revendication 6 ou selon la revendication 7, **caractérisé en ce que** l'application de nouvelles autres couches comprend une couche conductrice (23) qui est déposée sur la couche de distribution de courant (21, 22).

9. Procédé de production selon les revendications précédentes 6 à 8, **caractérisé en ce que** le côté du substrat (1) qui est destiné à l'application de la couche de distribution de courant (21, 22) est revêtu d'une couche de transmission (6) d'un matériau transparent ayant un indice de réfraction élevé avant que la couche de distribution de courant (21, 22) ne soit déposée.

10. Procédé de production selon la revendication 9, **caractérisé en ce que** la couche de transmission (6) comprend du dioxyde de titane.
